# EUROPEAN PATENT SPECIFICATION

(11) **EP 3 798 564 B1**
(45) Date of publication and mention of the grant of the patent: **03.08.2022**
(21) Application number: 19200270.7
(22) Date of filing: 27.09.2019
(51) Int. Cl.: F28D 15/02, F28D 15/04, H01L 23/427

(54) **VAPOR CHAMBER FOR COOLING AN ELECTRONIC COMPONENT**
DAMPFKAMMER ZUR KÜHLUNG EINER ELEKTRONISCHEN KOMPONENTE
CHAMBRE DE VAPEUR DE REFROIDISSEMENT D'UN COMPOSANT ÉLECTRONIQUE

(43) Date of publication of application: 31.03.2021
(73) Proprietor: ABB Schweiz AG, 5400 Baden (CH)
(72) Inventor: Bortolato, Matteo, 35010 Trebaseleghe (IT); Agostini, Bruno, 8006 Zurich (CH); Petrov, Andrey, 8048 Zurich (CH); Torresin, Daniele, 5400 Baden (CH)
(74) Representative: Qip Patentanwälte Dr. Kuehn & Partner mbB

(56) References cited:
- WO-A1-2018/199216
- DE-C- 910 308
- JP-A- H10 209 356
- US-A1- 2004 016 534
- US-A1- 2010 294 200
- US-A1- 2011 088 875
- US-A1- 2017 023 308

## Description

### Technical Field

The invention relates to a vapor chamber for cooling an electronic component, such as for cooling a power semiconductor device. The present invention particularly relates to a cooling chamber having an improved mechanical stability and is further easy to produce.

### Background Art

Vapor chambers are known in the art. Such vapor chambers are used for dissipating heat such as from electronic parts. Additionally to two-dimensional vapor chambers, so-called three-dimensional vapor chambers are known which comprise an evaporator and at least a condenser being provided in a T-like arrangement.

The current ratings of power electronic devices are continuously increasing while maintaining or even reducing their footprint. This leads to higher heat loss densities which require advanced cooling concepts. In fact, traditional Aluminum or Copper heat sinks are limited by heat flux densities of 10 W/cm². Recently vapor chamber heat sinks which are state of the art technology used in CPU cooling, have emerged as a valid alternative compared to water cooling for high heat flux densities in the power electronic applications

US 2017/0023308 A1 describes a slim vapor chamber including a first plate, a second plate and a capillary structure. The periphery of the second plate is connected with that of the first plate to form a chamber. The capillary structure is disposed in the chamber. At least one of a side of the first plate facing the second plate and a side of the second plate facing the first plate is formed with a plurality of supporting structures, which include a plurality of supporting pillars and a plurality of supporting plates, by an etching process. It is further described that a cross-section of the supporting pillar is circular, elliptic, triangular, rectangular, rhombic, trapezoidal, or polygonal.

US 2010/0294200 A1 describes a vapor chamber including a sealed flattened casing containing working liquid therein, a wick structure arranged on an inner face of the casing, a supporting plate received in the casing and a plurality of supporting posts. The supporting plate defines a plurality of fixing holes therein. The supporting posts are engagingly received in the fixing holes of the supporting plate. Top and bottom ends of the supporting posts engage with the wick structure to reinforce a structure of the vapor chamber. Each supporting post has a diameter gradually increasing from one end to another opposite end thereof. A diameter of the middle of each supporting post is slightly larger than an aperture of the fixing hole, whereby the middle of the supporting post is interferingly fitted in the fixing hole of the supporting plate.

However, the prior art as discussed above still gives room for improvements. In particular, the cited prior art gives room for improvements with regard to enhancing the stability of the vapor chamber especially in case the vapor chamber can be formed easily.

### Summary of invention

It is therefore an object of the invention to overcome at least one disadvantage of the prior art at least in part. In particular, it is an object of the present invention to provide a vapor chamber having an improved stability.

These objects are solved at least in part by a vapor chamber having the features of independent claim 1. These objects are further solved at least in part by a method having the features of independent claim 8. Advantageous embodiments are given in the dependent claims, in the further description as well as in the figures, wherein the described embodiments can, alone or in any combination of the respective embodiments, provide a feature of the present invention unless not clearly excluded.

Described is a vapor chamber, comprising a sealed casing which comprises two main walls, wherein a first main wall is an evaporator wall and a second main wall is a condenser wall, wherein the two main walls are connected by side connections to form a sealed volume inside the two main walls and the side connections, wherein a plurality of pillars is provided in the sealed volume such, that the pillars connect the evaporator wall and the condenser wall, wherein the pillars have a first contact area to the evaporator wall and a second contact area to the condenser wall, and wherein the pillars further comprise an intermediate cross section area being arranged between the first contact area and the second contact area, wherein the extension of the intermediate cross section area is smaller compared to the extension of both of the first contact area and the second contact area.

Such a vapor chamber has significant advantages over the solutions of the prior art and may particularly provide enhanced mechanical stability and is further easy to manufacture.

Subject-matter of the present invention is thus a vapor chamber in particular for cooling a power semiconductor module or for cooling further electronic devices. The vapor chamber can thus be mounted, for example, to a baseplate of the power semiconductor module in order to cool the power semiconductor module or it can be mounted to further electronic devices in order to dissipate heat.

Vapor chambers are typically particular types of heat pipes, having the thickness much smaller than the other two dimensions. For this reason, they are also referred as flat heat pipes or 2-D heat pipes in some embodiments. Since, they can transfer the heat in two dimensions, they are also defined as two-phase heat spreaders. This peculiarity makes vapor chambers very interesting to spread high heat fluxes from small heat sources like chips in power modules and achieve an efficient usage of the heat transfer area towards the cooling medium, such as air or water. However, it is not excluded that heat pipes are three dimensional heat pipes having a kind of T-structure.

The vapor chamber comprises a sealed casing thus forming a sealed chamber. The sealed casing is designed for accommodating and thus for being filled with a working fluid like described in more detail below. The sealed casing comprises two main walls, which may be formed in a plate-like manner. The main walls may define the two dimensions as described above and thus the thickness being much smaller than these two dimensions is referred to the thickness between the first main wall and the second main wall.

The first main wall is an evaporator wall and thus is configured for coming in contact to the part to be cooled. For example, the first main wall may be a lower wall, or lower plate, respectively. The second main wall is a condenser wall and thus is configured for coming in contact with a comparably cool environment. For example, the second main wall may be an upper wall, or upper plate, respectively.

The two main walls are connected by side connections to form the sealed volume inside the two main walls and the side connections. For example, the side walls may proceed perpendicular to the main walls, wherein the arrangement of these walls, however, is not limited to this example. The two main walls as well as the side connections may thus form the casing or in other words, the casing may consist of the two main walls and the side connections.

Such a vapor chamber works according to the principle as generally known in the art. Following the normal operation, the working fluid being provided in the sealed volume comes in contact with the evaporator, which is in contact with the heat source, and thus vaporizes. On the other surface, i.e. the condenser wall, which may be in contact with a heat sink, the temperature is lower, thus the local saturation pressure is lower. This pressure difference drives the vapor from the evaporation zone to the condensation zone. After condensing at the condensation zone, i.e. at the condenser wall, the liquid is brought back to the evaporator e.g. by means of an inner wick structure. The wick structure mostly is a capillary structure, such as a three-dimensional mesh, which effectively guides the condensed working fluid back to the evaporator and is for these reasons arranged at the inner surface of the casing.

Due to the presence of a saturated vapor in the whole evaporator, the temperature distribution on the baseplate of the power module is pretty uniform, such as generally within 2-3 K in a properly working system, even when different sources with different power densities are present. Maintaining an almost isothermal baseplate is beneficial for the effective operation and long-term reliability of the different power electronics devices embedded in each module.

Generally, a vapor chamber is an advantageous alternative to coolers using cooling liquids. In detail, vapor chambers are emerging as the alternative solutions to water cooling for high heat flux densities in power electronic. Like indicated above, the vapor chamber utilizes the advantages of the latent heat needed for the evaporation and condensation processes in that the heat input to the evaporator vaporizes the working liquid provided inside the recirculation system, which flows to the condenser surfaces. After the vapor condenses on the condenser surfaces, e.g. capillary forces in the wick return the condensate to the evaporator.

Further and in order to withstand the fluid pressure cycles and the mounting pressure of the heat source, the vapor chamber is provided with inner pillars, also called posts. With this regard, a plurality of pillars is provided in the sealed volume such, that the pillars connect the evaporator wall and the condenser wall. Such pillars thus serve for improved robustness and mechanical stability during assembly of the vapor chamber to a part to be cooled and additionally during working of the vapor chamber.

In some applications, the mounting pressure may represent an issue and it has to be checked that the inner structure including the pillars for internal pressure variations is able to withstand also external pressure.

In the state-of-the-art manufacturing process, the internal posts of the vapor chambers have shapes either of a parallelepiped or of a cylinder. They are either machined directly on the evaporator surface and welded afterwards on the condenser surface or obtained by copper rod, surface-finished and joined to evaporator and condenser surface. This manufacturing method limits the maximum inner pressure of the vapor chamber to around 6 bar and the maximum mounting pressure to 4-5 bar.

Consequently, eligible working fluids for vapor chambers are limited to those having low pressure, high surface tension and high latent heat in the working range from - 20°C up to 150°C like water, acetone, ethanol and methanol. Other solutions using refrigerants employ geometries with capillary channels, which are gravity driven and can work with modest heat fluxes. The actual working temperature range is dependent on the chosen working fluid.

The main limitation of vapor chambers according to the prior art is inherent to the working principle: like heat pipes, these devices can reach critical conditions (i.e. dry-out) if the vapor or liquid flow is somehow prevented. Thus, the design of the inner capillary structure, the wall thickness and the total thickness of the vapor chambers are strictly related to the application, to the operating conditions and to the working fluid. In particular, when the vapor chamber is very thin, such as 0.5 mm, the cross section for the vapor flow is reduced and this limit the heat transfer capability and the maximum manageable heat flux.

The above drawbacks with regard to limited mechanical stability may be overcome by the vapor chamber as described. With this regard, it is provided that the pillars have a first contact area to the evaporator wall and a second contact area to the condenser wall, and the pillars further comprise an intermediate cross section area being arranged between the first contact area and the second contact area, wherein the extension of the intermediate cross section area is smaller compared to the extension of both of the first contact area and the second contact area. In other words, the area of cross section of the pillars at the contact area to both of the main walls is larger compared to an inner area of cross section.

It may be provided that the contact area of the pillars to the evaporator wall and the condenser wall are similar or differ from each other.

It could be found that such an arrangement significantly improves the mechanical strength of the vapor chamber thus leading to an improved mechanical stability. With this regard, it becomes possible to increase both of the maximum inner pressure of the vapor chamber and the maximum mounting pressure.

Consequently, eligible working fluids for vapor chambers are no longer limited to those having low pressure, high surface tension and high latent heat in the working range from -20°C up to 150°C like water, acetone, ethanol and methanol. In contrast to this, further embodiments are possible, thus enlarging the possible application areas and cooling capacity.

The working fluid may thus be easily adapted to the specific application. This is important, as the adopted working fluid defines the temperature operating range of the vapor chambers. Out of this temperature range, evaporation and condensation are prevented and the vapor chamber transfers heat only by conduction. In this situation, it causes a significant increase of the total thermal resistance with respect to a metal heat sink and all the potential benefits are lost.

Apart from that, the danger of damages during assembly of the vapor chamber and the part to be cooled is significantly reduced. Thus, the reliability of the vapor chamber is also improved.

It may be preferred that the pillars at least in part have an outer surface which is at least in part provided with a curvature proceeding from the evaporator wall to the condenser wall. When providing a curvature, sharp edges for changing the area of cross section can be avoided which in turn further improves the stability of the pillars and consequently of the vapor chamber. Thus, the advantages as described before are especially effective when forming the pillars as described in this embodiment.

The curvature may be provided at the whole outer surface of the pillar, or a respective curvature may be present only at a part of the outer surface of the pillar.

With regard to the curvature, it may be preferred that that the curvature forms a concave structure. With this regard, a concave structure may be an easy way to allow that a curvature is formed such, that the pillars have a first contact area to the evaporator wall and a second contact area to the condenser wall, and wherein the pillars further comprise an intermediate cross section area being arranged between the first contact area and the second contact area, wherein the extension of the intermediate cross section area is smaller compared to the extension of both of the first contact area and the second contact area. Concave structures are well known in the art and may thus be adapted in a very defined manner to the desired needs and in particular to the required stability and strength of the pillars and the vapor chamber.

Like cited above, the concave structure may be present at the whole outer surface so that a cross section going in a plane being arranged perpendicular to both the main walls may show a biconcave structure, or a plano-concave structure may be provided, for example and not limited thereto.

As compared to a state-of-the-art vapor chambers having cylindrical or parallelepiped inner pillars, given the same dimensions, the use of pillars with the geometrical features as described allow to have a larger vapor space for the vapor flow. The vapor has a direct effect on the overall thermal power that can be dissipated by a vapor chamber-based heat sink.

Further, in the various cross-sections going in a plane being arranged parallel to both the main walls, the structure can be represented with various shapes, e.g. circular, oval, square, rectangular, cross-like or other, or a combination thereof. Picking a particular shape can be beneficial for reducing mass and increasing vapor space and depends on the type of heat load and mechanical load for a particular application.

It may further be preferred the pillars at least in part have an outer contact angle to at least one of the evaporator wall and to the condenser wall, wherein the outer contact angle is in a range of more than 90° and smaller than 180°. Especially this embodiment allows a high mechanical stability of the arrangement comprising the casing and the pillars. Thus, this embodiment allows the advantages as described before to appear in an especially effective manner.

An outer contact angle shall thereby mean an angle which is provided at the outside of the pillar to the inner wall of the evaporator wall and/or condenser wall or in other words between the surfaces which lay open in the inner volume of the casing.

It may further be preferred that the pillars are provided at least in part with a porous structure at their outer surface. With this regard, the whole outer surface may be provided with a porous structure or the surface of the pillars may only be in part provided with a porous structure. With this regard, it may be provided that only part of the pillars is provided with a porous structure whereas a porous structure at the other part of the pillars is missing, and/or it may be provided that each or a part of the pillars is provided with a porous structure such, that only a part of the respective single one or more pillars is provides with a porous structure. However, it may be preferred that the porous structure if present is provided such, that the porous structure, in particular the capillary structure, is provided in a continuous manner from the evaporator wall to the condenser wall.

This embodiment allows in a very effective manner to allow condensed working fluid to flow back to the evaporator wall and thus to improve the circulation of the working fluid as the wick structure is enlarged significantly. Thus, the cooling efficiency of the vapor chamber is further enhanced and thus a very high mechanical stability is combined with a high cooling capacity.

The same advantages may be reached by the advantageous feature according to which the pillars are provided at least in part with at least one groove, in particular a plurality of grooves, proceeding from the evaporator wall to the condenser wall.

With this regard, correspondingly to the porous structure, the whole outer surface may be provided with one or more grooves or the surface of the pillars may only be in part provided with one or more grooves. With this regard, it may be provided that only part of the pillars is provided with one or more grooves whereas grooves at the other part of the pillars is missing, and/or it may be provided that each or a part of the pillars is provided with one or more grooves such, that only a part of the respective single one or more pillars is provides with one or more grooves.

It may be especially preferred that the at least one groove has at least one of a depth and a width in the range of 5 µm to 500 µm. It was found that especially grooves which are designed with such a size allow the effect of improving the working liquid to flow down to the evaporator is improved in an especially effective manner.

It may further be preferred that the that the smallest extension of an intermediate cross section area is smaller compared to the extension of both of the first contact area and the second contact area in a ratio of 1 to 100, such as 1 to 50, for example 1 to 10, such as 1 to 2. It was surprisingly found that especially such an arrangement allows a high stability, so that the above-described advantages are reached in an especially effective manner, thereby not negatively influencing the working behaviour and thus the cooling behaviour of the vapor chamber.

The same may be applied in case the smallest intermediate cross section area has an extension in a range of 0,03 to 1950 mm², preferably of 0,2 to 300 mm². Even though the above described effect may be reached reliably, the thickness of the pillars is large enough in order not to reduce the stability of the pillars as such in a too significant manner. Thus, the thickness of the pillars does not counteract to the achieved improvement in mechanical stability.

With regard to further advantages and technical features of the vapor chamber as described, it is further referred to the method, the figures, and the description of the figures.

Further described is a method for producing a vapor chamber like described in detail before, wherein at least a structure comprising the two main walls and the pillars connecting the two main walls is formed by additive manufacturing.

The specific process of additive manufacturing, also called 3D-printing, may be used according to the required needs. The mentioned additive manufacturing techniques can include Selective Laser Sintering/Melting (SLS/SLM), Laser Metal Deposition/Direct Metal Deposition (LMD/DMD), Binder-Jetting (BJ) or others. First thermally working 3-D printed prototypes exhibit a burst pressure of around 40 bars. This means that with further optimization, a vapor chamber like described can work at higher temperatures with the commonly used fluids or could also be filled with other fluids having interesting thermal properties such as ammonia or even some low-pressure refrigerants like R1234zd.

State-of-the-art vapor chamber have a maximum working pressure of 5 bar, that is to say that the maximum working temperature is of 150°C when filled with water, 110°C when filled with methanol or acetone. With improved pillars, the maximum temperature is increased to 250°C for water or 200°C for methanol.

Using additive manufacturing for forming the respective structures may overcome the difficulty of manufacturing and joining complex structures, which brings the required geometrical flexibility and allows to customize the cooler for a particular device design. Thus, the different cross sections of the main walls as well as the pillars may be achieved in an especially defined and reliable manner, thereby also being cost-saving.

These advantages may be especially effective in case at least the two main walls comprise a porous structure and in that the pillars are provided with a porous structure or a groove structure at least a part of their outer surface, wherein the porous structure of the two main walls and the porous structure or the groove structure of the pillars are formed in a continuous manner.

Generally, additive manufacturing may be used for example in a vapor chamber manufacturing process for forming bulk structures, such as the walls, porous structures, such as the capillary wick structure at the walls as well as the pillars.

Especially this arrangement is not sufficiently possible by using conventional manufacturing processes but is possible without problems by using additive manufacturing.

In more detail, the porous structures, such as the capillary structure, and/or the groove structure may be formed very flexibly and thus can be adapted to the desired needs and in particular to the adjacent structure. This allows that the structure of the main walls and the pillars is not negatively affected. It can thus be allowed that continuity of the structures of the main walls and of the pillars is maintained in a very detailed and effective manner and thus no border is provided between these structures. Therefore, the condensed working fluid can effectively be guided back to the evaporator wall, allowing a very effective working behaviour of the formed vapor chamber.

With regard to further advantages and technical features of the method as described, it is further referred to the vapor chamber, the figures, and the description of the figures.

### Brief description of drawings

These and other aspects of the invention will be apparent from and elucidated with reference to the embodiments described hereinafter.

In the drawings:
Fig. 1 shows a sectional side view of a vapor chamber according to an embodiment of the invention;
Fig. 2 shows a pillar for a vapor chamber according to figure 1;
Fig. 3 shows the effect of a vapor chamber according to the invention on the stress distribution; and
Fig. 4 shows various perpendicular cross-sections of a pillar for a vapor chamber according to figures 1 and 2.

### Description of embodiments

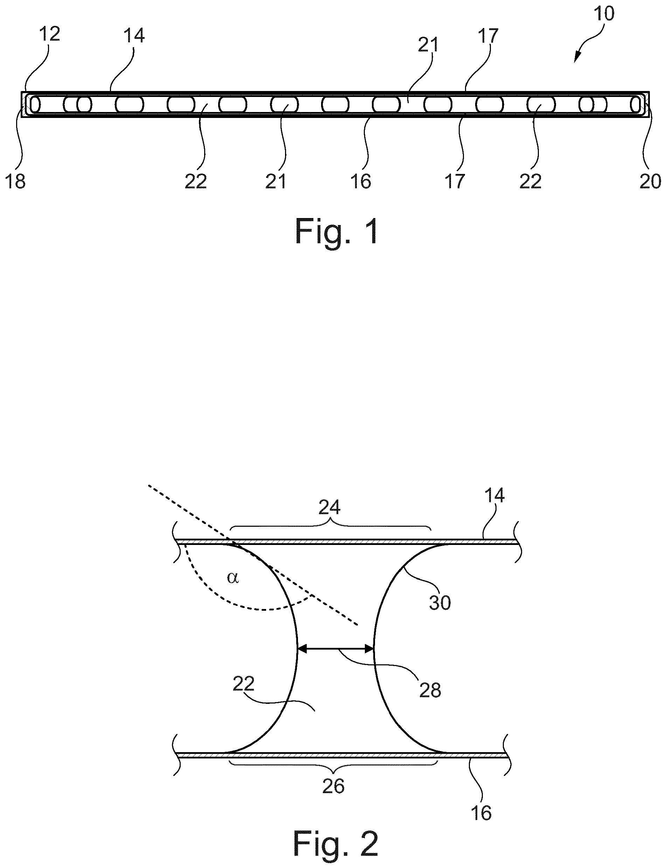

Fig. 1 shows a vapor chamber 10 which is particularly suited for cooling an electronic device, such as a power semiconductor module, not shown as such.

The vapor chamber 10 comprises casing 12 which is sealed to the outside so that a working fluid which is included in the casing 12 is not able to leave the casing 12 either in liquid or in gaseous form. The casing 12 comprises two main walls. The two main walls comprise an evaporator wall 14 and a condenser wall 16. The evaporator wall 14 is configured for coming in contact with a device to be cooled, such as with a baseplate of a power semiconductor module. The condenser wall 16 is configured for being in an environment having a comparably cooler temperature. For example, the condenser wall 16 is provided at its outside with air fins.

The two main walls, i.e. the evaporator wall 14 and the condenser wall 16, are connected by side connections 18, 20 to form a sealed volume 21 inside the two main walls and the side connections 18, 20. Further, a wick structure 17 is provided at the inner surface of the evaporator wall 14 and the condenser wall 16 and/or side connections 18, 20.

Figure 1 further shows that a plurality of pillars 22 is provided in the sealed volume 21 such, that the pillars 22 connect the evaporator wall 14 and the condenser wall 16. The pillars 22 have a first contact area 24 to the evaporator wall 14 and a second contact area 26 to the condenser wall 16. It is further provided that the pillars 22 are formed such, that they comprise an intermediate cross section area 28 being arranged between the first contact area 24 and the second contact area 26. It is provided that the extension of the intermediate cross section area 28 is smaller compared to the extension of both of the first contact area 24 and the second contact area 26.

The pillar 22 is shown in more detail in figure 2. As already mentioned with regard to figure 1, it is shown that the pillar 22 is formed such, that it comprises the intermediate cross section area 28 being arranged between the first contact area 24 and the second contact area 26, wherein it is provided that the extension of the intermediate cross section area 28 is smaller compared to the extension of both of the first contact area 24 and the second contact area 26. In more detail, it may be provided that the smallest extension of an intermediate cross section area 28 is smaller compared to the extension of both of the first contact area 24 and the second contact area 26 in a ratio of 1 to 100.

This is realized in that the pillar 22 has an outer surface 30 which is at least in part provided with a curvature proceeding from the evaporator wall 14 to the condenser wall 16. In more detail, it is provided that the curvature forms a concave structure. It is thus allowed that the pillar 22 has an outer contact angle α to the evaporator wall 14 and the condenser wall 16, wherein the outer contact angle α is in a range of more than 90° and smaller than 180°. In detail the contact angle α to the condenser wall 16 is shown. The contact angle α to the condenser wall 16 may further be the same or different compared to the contact angle α to the evaporator wall 14.

It may further be provided that the outer surface of the pillar 22 is provided with a porous structure at the outer surface 30 and/or that the pillar 22 is provided with at least one, preferably a plurality of grooves, proceeding from the evaporator wall 14 to the condenser wall 16. This allows that no abrupt change of direction of the liquid on both main walls is present, so that it is prevented that the capillary pump effect of the wick structure is reduced.

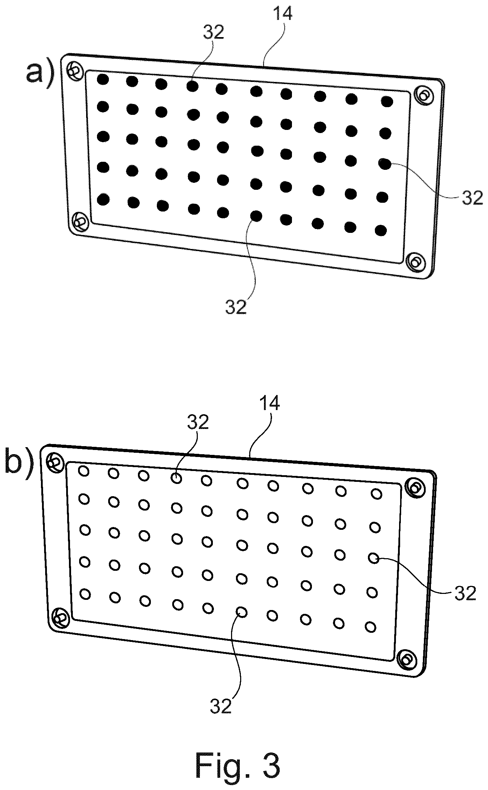

According to figure 3, the positive effect of the present invention is visualized. In detail, an evaporator wall 14 is shown for means of an example. The consequence of the feature according to which the pillars 22 further comprise an intermediate cross section area 28 being arranged between the first contact area 24 and the second contact area 26, wherein the extension of the intermediate cross section area 28 is smaller compared to the extension of both of the first contact area 24 and the second contact area 26 is shown. This allows for significant reduction of spot stresses as indicated in figure 3 by stress points 32, wherein figure 3a shows stress points by using conventional pillars and figure 3b shows stress points 32 by using pillars 22 as described above. In figure 3a by using black-filled stress points 32, a high local mechanical spot stress should be indicated whereas according to figure 3b and by using white-filled stress points 32, a low and thus reduced mechanical spot stress should be indicated.

As demonstrated by numerical mechanical simulation, pillars 22 according to the present invention decrease the local stress in the flat surfaces of a vapor chamber 10 by 30 % - 40%. Reduced stresses lead to extended lifetime and reliability of the vapor chamber 10.

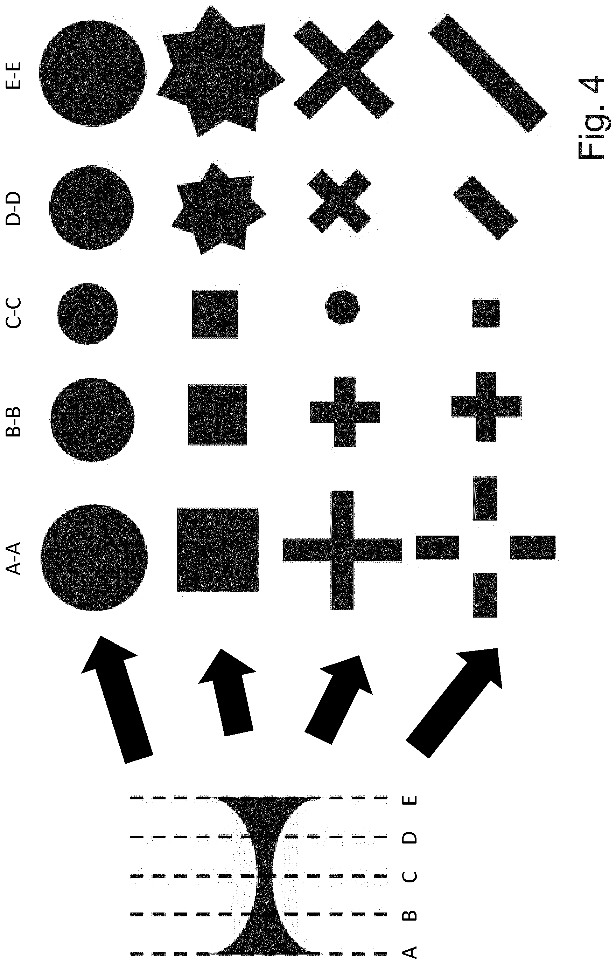

Figure 4 shows examples of cross section shapes for pillars 22 that can be embedded in the vapor chamber 10. In more detail, on the left-hand side, a side view of a pillar 22 is shown, in which different cross section planes A to E are defined. On the right-hand side, the geometry of these distinct cross section planes is shown, wherein each horizontal line refers to one common pillar 22.

Generally, it can be seen that the geometry of the pillars 22 can be selected according to the desired needs and no specific form or symmetry is mandatory. With regard to the following shapes, these may also called cross-sectional shape or geometry.

According to the first line, the pillar 22 comprises a round shape at the whole length of the pillar 22, i.e. from the evaporator wall 14 to the condenser wall 16.

According to the second line, the pillar 22 comprises at one end a rectangular shape and on the other end a starlike shape, wherein the end having a rectangular shape may be both the evaporator end or the condenser end.

According to the third line, the pillar 22 comprises at both ends a shape having the form of a cross, wherein, however, the orientation differs such, that the cross is turned around an angle of 45° along the axis of the pillar 22. At the center part, the form has a shape of a hexagon, which, however, could also be a round shape, for example.

According to the fourth line, the pillar 22 comprises an arbitrary shape in which every cross sectional plane A to E has a different shape. This row shows that the form of the pillar 22 may be chosen according to the desired needs.

A vapor chamber 10 as described thus provides an innovative geometry of inner supporting pillars 22. The improved structure allows a higher inner working pressure and a higher mounting pressure since the stress on the flat plates, i.e. the evaporator wall 14 and the condenser wall 16 is reduced by 30-40% as compared to the traditional vapor chambers 10 with cylindric or parallelepiped pillars. Thus, with commonly used fluids, the maximum working temperature can be increased as compared to the state-of-the-art vapor chambers and the use of high-pressure fluids with very good thermal properties as ammonia or even low-pressure refrigerant like R1234zd is also possible. The concave curvature of the pillars 22 with vapor chambers' flat plates, i.e. the evaporator wall 14 and the condenser wall 16 reduce the pressure drop of the liquid flow from the evaporator wall 14 to the condenser wall 16. Furthermore, the vapor space is increased. This improves the thermal performance. As an example, vapor chambers 10 with innovative shapes of the pillars 22 can be cost-effectively produced by additive manufacturing

Generally, vapor chambers 10 are emerging as the alternative solutions to water cooling for high heat flux densities in power electronic. In order to function as an air heat sink, metallic full bodied lamellas are bonded to condenser side of the vapor chamber 10 increasing the heat transfer area. The heat exchange from the lamellas to the air is the limiting factor of vapor chamber based heat sink coolers because standard type of air fins, such as full bodied lamellas, do not provide high heat transfer coefficient (turbulence) for the air side and also are subjected to the physical limitation due to the fin efficiency. To cope with very high heat losses, three dimensional vapor chamber 10 can be used. In this case, an evaporator and at least one condenser are provided in a T-like arrangement to increase the fin efficiency and the heat transfer to the surrounding area.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: vapor chamber
- 12: casing
- 14: evaporator wall
- 16: condenser wall
- 17: wick structure
- 18: side connection
- 20: side connection
- 21: volume
- 22: pillar
- 24: first contact area
- 26: second contact area
- 28: intermediate cross section area
- 30: outer surface
- 32: stress point

## Claims

1. A vapor chamber (10), comprising a sealed casing (12) which comprises two main walls, wherein a first main wall is an evaporator wall (14) and a second main wall is a condenser wall (16), wherein the two main walls are connected by side connections (18, 20) to form a sealed volume (21) inside the two main walls and the side connections (18, 20), wherein a plurality of pillars (22) is provided in the sealed volume (21) such, that the pillars (22) connect the evaporator wall (14) and the condenser wall (16), wherein the pillars (22) have a first contact area (24) to the evaporator wall (14) and a second contact area (26) to the condenser wall (16), and wherein the pillars (22) further comprise an intermediate cross section area (28) being arranged between the first contact area (24) and the second contact area (26), **characterized in that** the extension of the intermediate cross section area (28) is smaller compared to the extension of both of the first contact area (24) and the second contact area (26).

2. The vapor chamber (10) according to claim 1, **characterized in that** the pillars (22) at least in part have an outer surface (30) which is at least in part provided with a curvature proceeding from the evaporator wall (14) to the condenser wall (16).

3. The vapor chamber (10) according to claim 2, **characterized in that** the curvature forms a concave structure.

4. The vapor chamber (10) according to any of claims 1 to 3, **characterized in that** the pillars (22) at least in part have an outer contact angle α to at least one of the evaporator wall (14) and to the condenser wall (16), wherein the outer contact angle is in a range of more than 90° and smaller than 180°.

5. The vapor chamber (10) according to claim 1, **characterized in that** the pillars (22) are provided at least in part with a porous structure at their outer surface (30).

6. The vapor chamber (10) according to claim 1, **characterized in that** the pillars (22) are provided at least in part with at least one groove proceeding from the evaporator wall (14) to the condenser wall (16).

7. The vapor chamber (10) according to claim 1, **characterized in that** the at least one groove has at least one of a depth and a width in the range of 5 µm to 500 µm.

8. The vapor chamber (10) according to claim 1, **characterized in that** the smallest extension of an intermediate cross section area (28) is smaller compared to the extension of both of the first contact area (24) and the second contact area (26) in a ratio of 1 -100.

9. A method for producing a vapor chamber (10) according to any of claims 1 to 8, **characterized in that** at least a structure comprising the two main walls and the pillars (22) connecting the two main walls is formed by additive manufacturing.

10. The method according to claim 9, **characterized in that** at least the two main walls comprise a porous structure and **in that** the pillars (22) are provided with a porous structure or a groove structure at at least a part of their outer surface, wherein the porous structure of the two main walls and the porous structure or the groove structure of the pillars (22) are formed in a continuous manner.

## Patentansprüche

1. Dampfkammer (10), umfassend ein abgedichtetes Gehäuse (12), das zwei Hauptwände umfasst, wobei eine erste Hauptwand eine Verdampferwand (14) ist und eine zweite Hauptwand eine Kondensatorwand (16) ist, wobei die zwei Hauptwände durch seitliche Verbindungen (18, 20) verbunden sind, um ein abgedichtetes Volumen (21) innerhalb der zwei Hauptwände und der seitlichen Verbindungen (18, 20) zu bilden, wobei eine Mehrzahl von Säulen (22) in dem abgedichteten Volumen (21) derart bereitgestellt ist, dass die Säulen (22) die Verdampferwand (14) und die Kondensatorwand (16) verbinden, wobei die Säulen (22) einen ersten Kontaktbereich (24) zu der Verdampferwand (14) und einen zweiten Kontaktbereich (26) zu der Kondensatorwand (16) aufweisen, und wobei die Säulen (22) ferner einen Zwischenquerschnittsbereich (28) aufweisen, der zwischen dem ersten Kontaktbereich (24) und dem zweiten Kontaktbereich (26) angeordnet ist, **dadurch gekennzeichnet, dass** die Erstreckung des Zwischenquerschnittsbereichs (28) im Vergleich zu der Erstreckung sowohl des ersten Kontaktbereichs (24) als auch des zweiten Kontaktbereichs (26) kleiner ist.

2. Dampfkammer (10) nach Anspruch 1, **dadurch gekennzeichnet, dass** die Säulen (22) zumindest teilweise eine Außenfläche (30) aufweisen, die zumindest teilweise mit einer Krümmung versehen ist, die von der Verdampferwand (14) zu der Kondensatorwand (16) verläuft.

3. Dampfkammer (10) nach Anspruch 2, **dadurch gekennzeichnet, dass** die Krümmung eine konkave Struktur bildet.

4. Dampfkammer (10) nach einem der Ansprüche 1 bis 3, **dadurch gekennzeichnet, dass** die Säulen (22) zumindest teilweise einen Außenkontaktwinkel α zu mindestens einer der Verdampferwand (14) und der Kondensatorwand (16) aufweisen, wobei der Außenkontaktwinkel in einem Bereich von mehr als 90° und kleiner als 180° liegt.

5. Dampfkammer (10) nach Anspruch 1, **dadurch gekennzeichnet, dass** die Säulen (22) zumindest teilweise mit einer porösen Struktur an ihrer Außenfläche (30) versehen sind.

6. Dampfkammer (10) nach Anspruch 1, **dadurch gekennzeichnet, dass** die Säulen (22) zumindest teilweise mit mindestens einer Nut versehen sind, die von der Verdampferwand (14) zu der Kondensatorwand (16) verläuft.

7. Dampfkammer (10) nach Anspruch 1, **dadurch gekennzeichnet, dass** die mindestens eine Nut eine Tiefe und eine Breite im Bereich von 5 µm bis 500 µm aufweist.

8. Dampfkammer (10) nach Anspruch 1, **dadurch gekennzeichnet, dass** die kleinste Erstreckung eines Zwischenquerschnittsbereichs (28) im Vergleich zu der Erstreckung sowohl des ersten Kontaktbereichs (24) als auch des zweiten Kontaktbereichs (26) in einem Verhältnis von 1-100 kleiner ist.

9. Verfahren zum Herstellen einer Dampfkammer (10) nach einem der Ansprüche 1 bis 8, **dadurch gekennzeichnet, dass** zumindest eine Struktur, die die zwei Hauptwände und die Säulen (22) umfasst, die die zwei Hauptwände verbinden, durch additive Fertigung ausgebildet wird.

10. Verfahren nach Anspruch 9, **dadurch gekennzeichnet, dass** zumindest die zwei Hauptwände eine poröse Struktur umfassen, und dadurch, dass die Säulen (22) an zumindest einem Teil ihrer Außenfläche mit einer porösen Struktur oder einer Nutstruktur versehen sind, wobei die poröse Struktur der zwei Hauptwände und die poröse Struktur oder die Nutstruktur der Säulen (22) in einer durchgehenden Weise ausgebildet werden.

## Revendications

1. Chambre de vapeur (10), comprenant une enveloppe étanche (12) qui comprend deux parois principales, une première paroi principale étant une paroi d'évaporateur (14) et une seconde paroi principale étant une paroi de condenseur (16), les deux parois principales étant reliées par des liaisons latérales (18, 20) pour former un volume étanche (21) à l'intérieur des deux parois principales et des liaisons latérales (18, 20), une pluralité de piliers (22) étant prévus dans le volume étanche (21) de sorte que les piliers (22) relient la paroi d'évaporateur (14) et la paroi de condenseur (16), les piliers (22) ayant une première zone de contact (24) avec la paroi de l'évaporateur (14) et une seconde zone de contact (26) avec la paroi du condenseur (16), et les piliers (22) comprenant en outre une zone de section transversale intermédiaire (28) agencée entre la première zone de contact (24) et la seconde zone de contact (26), **caractérisé en ce que** l'extension de la zone de section transversale intermédiaire (28) est inférieure à l'extension de la première zone de contact (24) et de la seconde zone de contact (26).

2. Chambre de vapeur (10) selon la revendication 1, **caractérisée en ce que** les piliers (22) ont au moins en partie une surface extérieure (30) qui est au moins en partie pourvue d'une courbure allant de la paroi de l'évaporateur (14) à la paroi du condenseur (16).

3. Chambre de vapeur (10) selon la revendication 2, **caractérisée en ce que** la courbure forme une structure concave.

4. Chambre de vapeur (10) selon l'une quelconque des revendications 1 à 3, **caractérisée en ce que** les piliers (22) ont au moins en partie un angle de contact extérieur α avec au moins l'une de la paroi d'évaporateur (14) et de la paroi de condenseur (16), l'angle de contact extérieur étant dans une plage allant de plus de 90° à moins de 180°.

5. Chambre de vapeur (10) selon la revendication 1, **caractérisée en ce que** les piliers (22) sont pourvus au moins en partie d'une structure poreuse au niveau de leur surface extérieure (30).

6. Chambre de vapeur (10) selon la revendication 1, **caractérisée en ce que** les piliers (22) sont pourvus au moins en partie d'au moins une rainure allant de la paroi de l'évaporateur (14) à la paroi du condenseur (16).

7. Chambre de vapeur (10) selon la revendication 1, **caractérisée en ce que** ladite au moins une rainure a au moins l'une d'une profondeur et d'une largeur dans la plage de 5 µm à 500 µm.

8. Chambre de vapeur (10) selon la revendication 1, **caractérisée en ce que** la plus petite extension d'une zone de section transversale intermédiaire (28) est plus petite par rapport à l'extension à la fois de la première zone de contact (24) et de la seconde zone de contact (26) dans un rapport de 1-100.

9. Procédé de fabrication d'une chambre de vapeur (10) selon l'une quelconque des revendications 1 à 8, **caractérisé en ce qu'**au moins une structure comprenant les deux parois principales et les piliers (22) reliant les deux parois principales est formée par fabrication additive.

10. Procédé selon la revendication 9, **caractérisé en ce qu'**au moins les deux parois principales comprennent une structure poreuse et **en ce que** les piliers (22) sont pourvus d'une structure poreuse ou d'une structure de rainure sur au moins une partie de leur surface extérieure, la structure poreuse des deux parois principales et la structure poreuse ou la structure de rainure des piliers (22) étant formées de manière continue.
